# EUROPEAN PATENT APPLICATION

(11) **EP 2 891 894 A2**
(43) Date of publication of application: **08.07.2015**
(21) Application number: 14192867.1
(22) Date of filing: 12.11.2014
(51) Int. Cl.: G01R 33/12, G01R 33/06, G01N 27/72, G07D 7/04

(54) **Magnetic sensor**

(30) Priority: 28.11.2013 JP 2013246690
(71) Applicant: TDK Corporation, Tokyo 108-0023 (JP)
(72) Inventor: Aoki, Ryosuke, Tokyo 108-0023 (JP); Fukuoka, Seiji, Tokyo 108-0023 (JP); Kido, Toshinao, Tokyo 108-0023 (JP)
(74) Representative: Epping - Hermann - Fischer

(57) **Abstract**

A magnetic sensor comprises a bias magnetic field generating means and a magnetic detection element disposed on one side of the bias magnetic field generating means in a magnetic pole direction, and the magnetic sensor identifying a medium, that is a magnetic powder adhered medium or a magnetic film adhered medium, passing across the magnetic detection element on the side opposite to the bias magnetic field generating means. The magnetic detection element is capable of detecting variation in a magnetic field component parallel to a movement direction of the medium to be identified. A passage region of the medium includes a specific region in which a magnetic field increases when a distance from the magnetic detection element becomes larger in the magnetic pole direction.

## Description

### BACKGROUND OF THE INVENTION

### 1. Field of the Invention

The present invention relates to a magnetic sensor preferably used for a paper money identification device, for example.

### 2. Description of the Related Art

Automatic vending machines etc. are disposed with a paper money identification device identifying input paper money. The paper money identification device includes a magnetic sensor reading magnetic ink printed on paper money. For example, as described in Japanese Laid-Open Patent Publication No. 63-155579, the magnetic sensor has a magnet and a magnetic detection element disposed above a magnetic pole face of the magnet and detects magnetic variation associated with passage of paper money.

### SUMMARY OF THE INVENTION

Because of flapping during carrying of paper money, a distance between the magnetic pole face of the magnet and paper money slightly varies for each input and the output of the magnetic sensor varies each time even in the same type of paper money. From the viewpoint of output stabilization, such variations are preferably suppressed as small as possible. Such a problem commonly occurs even when a magnetic powder adhered medium or a magnetic film adhered medium other than paper money is identified.

The present invention was conceived in view of the situations and it is therefore an object of the present invention to provide a magnetic sensor capable of suppressing output variation due to flapping of an object to be identified as compared to a conventional one.

In the aspect of the present invention, a magnetic sensor comprises:
a bias magnetic field generating means; and
a magnetic detection element disposed on one side of the bias magnetic field generating means in a magnetic pole direction,
the magnetic sensor identifying a medium, that is a magnetic powder adhered medium or a magnetic film adhered medium, passing across the magnetic detection element on the side opposite to the bias magnetic field generating means,
the magnetic detection element being capable of detecting variation in a magnetic field component parallel to a movement direction of the medium to be identified,
a passage region of the medium including a specific region in which a magnetic field increases when a distance from the magnetic detection element becomes larger in the magnetic pole direction.

In the magnetic sensor, a magnetic field at a magnetic sensitive point of the magnetic detection element may increase in at least a portion of the medium, when the medium moves away from the magnetic detection element in the magnetic pole direction.

In the magnetic sensor, the bias magnetic field generating means may include two magnets, and the two magnets are arranged side by side across a gap and both have the same magnetic pole as a magnetic pole closer to the magnetic detection element.

In the magnetic sensor, the bias magnetic field generating means may include a hollow magnet having a through-hole penetrating therethrough in the magnetic pole direction, and the hollow magnet has the same magnetic pole on an entire end surface closer to the magnetic detection element.

In the magnetic sensor, the bias magnetic field generating means includes a magnet and two yokes disposed on one magnetic pole face of the magnet, and the two yokes are arranged side by side across a gap.

It is to be noted that any arbitrary combination of the above-described structural components as well as the expressions according to the present invention changed among a system and so forth are all effective as and encompassed by the present aspects.

According to the aspects described above, a magnetic sensor can be provided which is capable of suppressing output variation due to flapping of an object to be identified as compared to a conventional one.

### BRIEF DESCRIPTION OF DRAWING

Fig. 1 is a schematic plan view of a magnetic sensor according to a first embodiment of the present invention.
Fig. 2 is a schematic front view thereof.
Fig. 3 is a simulated view of magnetic fluxes generated by a hollow magnet 1 of Figs. 1 and 2.
Fig. 4 is a characteristic diagram of relationship between magnetic flux density generated by the hollow magnet 1 and distance.
Fig. 5 is a comparison diagram related to a first embodiment between a magnetic flux density vector B1 at a magnetic sensitive point 3a of a magnetic detection element 3 when a magnetic portion 4a of paper money 4 is close to the magnetic detection element 3 and a magnetic flux density vector B2 at the magnetic sensitive point 3a of the magnetic detection element 3 when the magnetic portion 4a of the paper money 4 is distant from the magnetic detection element 3.
Fig. 6 is a waveform diagram of output voltage of the magnetic sensor of the first embodiment when a measurement magnetic body is moved along a passage region of the paper money 4.
Fig. 7 is a characteristic diagram of relationship between a distance (gap) in the z-direction from an upper end surface of the magnetic detection element 3 to a passage region of the measurement magnetic body and a peak value (amplitude) of the output voltage of the magnetic sensor of the first embodiment when the measurement magnetic body is moved along the passage region of the paper money 4.
Fig. 8 is a schematic plan view of a magnetic sensor according to a second embodiment of the present invention.
Fig. 9 is a schematic front view thereof.
Fig. 10 is a schematic front view of a magnetic sensor according to a third embodiment of the present invention.
Fig. 11 is a perspective view of a bias magnetic field generating means of the magnetic sensor of Fig. 10.
Fig. 12 is a simulated view of magnetic fluxes generated by the bias magnetic field generating means of Fig. 11.
Fig. 13 is a characteristic diagram of relationship between magnetic flux density generated by the bias magnetic field generating means of Fig. 11 and distance.
Fig. 14 is a schematic plan view of a magnetic sensor of a comparison example.
Fig. 15 is a schematic front view thereof.
Fig. 16 is a characteristic diagram of relationship between magnetic flux density generated by a rectangular column magnet 80 and distance related to the comparison example.
Fig. 17 is a waveform diagram of output voltage of the magnetic sensor of the comparison example when the measurement magnetic body is moved along the passage region of the paper money 4.
Fig. 18 is a characteristic diagram of relationship between a distance (gap) in the z-direction from the upper end surface of the magnetic detection element 3 to the passage region of the measurement magnetic body and a peak value (amplitude) of the output voltage of the magnetic sensor of the comparison example when the measurement magnetic body is moved along the passage region of the paper money 4.

### DETAILED DESCRIPTION OF THE INVENTION

The invention will now be described based on the following embodiments which do not intend to limit the scope of the present invention but exemplify the invention. All of the features and the combinations thereof described in the embodiments are not necessarily essential to the invention.

### First Embodiment

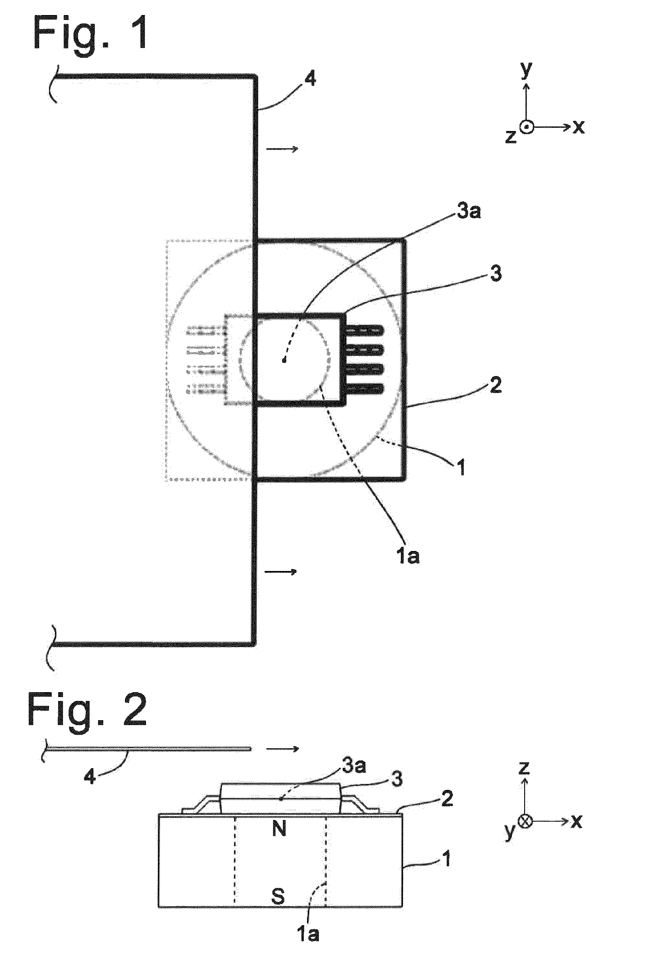

Fig. 1 is a schematic plan view of a magnetic sensor according to a first embodiment of the present invention. Fig. 2 is a schematic front view thereof. These figures define three orthogonal directions, i.e., an x-direction, a y-direction, and a z-direction. The magnetic sensor of this embodiment includes a hollow magnet 1 as a bias magnetic field generating means, a substrate 2, and a magnetic detection element 3. The hollow magnet 1 is in a tube shape having a through-hole 1a penetrating therethrough in the z-direction and is a circular tube magnet in this embodiment. A magnetic pole direction (magnetization direction) of the hollow magnet 1 is the z-direction and an end surface of the hollow magnet 1 on the positive side in the z-direction is entirely an N-pole while an end surface on the negative side in the z-direction is entirely an S-pole. The substrate 2 is disposed (fixed) onto the N-pole side end surface of the hollow magnet 1. The magnetic detection element 3 is mounted on the substrate 2. The magnetic detection element 3 is a Hall element or a magneto-resistance effect element (MR element) and is disposed such that variation in a magnetic field component in the x-direction can be detected. A magnetic sensitive point 3a of the magnetic detection element 3 is located on a center axis of the hollow magnet 1 (on a center axis of the through-hole 1a) . Paper money 4 to be identified is carried in the x-direction by a carrying system not depicted and passes across the magnetic detection element 3 on the positive side in the z-direction (the side opposite to the hollow magnet 1).

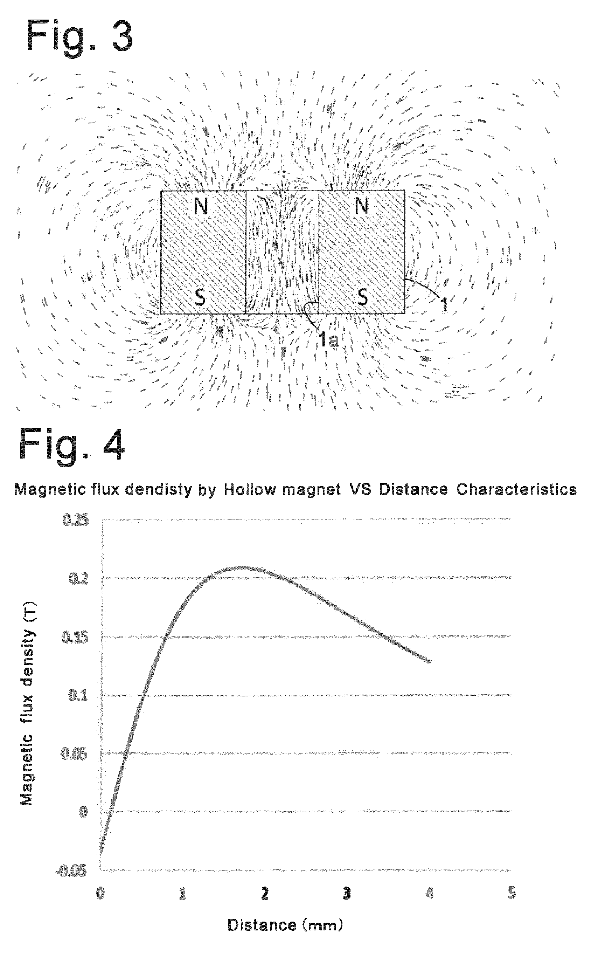

Fig. 3 is a simulated view of magnetic fluxes generated by the hollow magnet 1 of Figs. 1 and 2 and visually illustrates magnetic fluxes on a plane including the center axis of the hollow magnet 1 and parallel to the x-z plane. Fig. 4 is a characteristic diagram of relationship between magnetic flux density generated by the hollow magnet 1 and distance. The result depicted in Fig. 4 is based on a size of the hollow magnet 1 having an outer diameter of 10 mm, an inner diameter of 3 mm, and a height of 5 mm. In Fig. 4, a distance indicted by the horizontal axis is a distance from the center of an N-pole side opening of the through-hole 1a of the hollow magnet 1 to a magnetic flux density measurement point. The magnetic flux density measurement point ranges to a position at a distance of 4 mm from the center of the N-pole side opening of the through-hole 1a of the hollow magnet 1 on the positive side in the z-direction.

As depicted in Fig. 4, it is understood that the magnetic flux density increases in a range to a distance of about 0.2 to 1.5 mm from the center of the N-pole side opening of the through-hole 1a of the hollow magnet 1 as a distance from the center becomes larger. The magnetic flux density is made negative in a range equal to or less than 0.2 mm due to the effect of magnetic fluxes flowing from the N-pole through the through-hole 1a of the hollow magnet 1 to the S-pole as depicted in the simulated view of Fig. 3. The magnetic flux density increases as the distance becomes larger not only on the center axis of the hollow magnet 1 but also in a certain region in the vicinity of the center axis. This embodiment is configured such that a passage region of the paper money 4 to be identified includes a specific region in which the magnetic flux density increases as a distance from the hollow magnet 1 and the magnetic detection element 3 becomes larger on the positive side in the z-direction. As a result, output reduction can be suppressed when the passage region of the paper money 4 slightly deviates to the positive side in the z-direction due to flapping of the paper money 4. This effect will be described later.

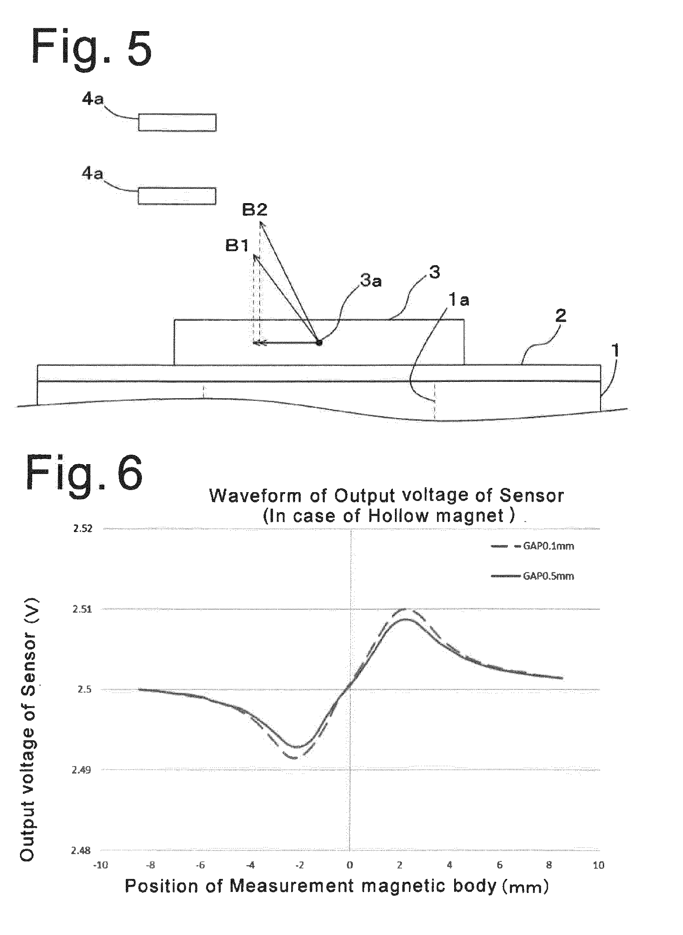

Fig. 5 is a comparison diagram between a magnetic flux density vector B1 at the magnetic sensitive point 3a of the magnetic detection element 3 when a magnetic portion 4a of the paper money 4 is close to the magnetic detection element 3 and a magnetic flux density vector B2 at the magnetic sensitive point 3a of the magnetic detection element 3 when the magnetic portion 4a of the paper money 4 is distant from the magnetic detection element 3. As depicted in Fig. 5, the magnetic flux density vector B2 in the case of the distant magnetic portion 4a of the paper money 4 forms an angle closer to 90 degrees relative to the x-direction as compared to the magnetic flux density vector B1 in the case of the close magnetic portion 4a of the paper money 4. On the other hand, the magnetic flux density vector B2 in the case of the distant magnetic portion 4a of the paper money 4 is larger than the magnetic flux density vector B1 in the case of the close magnetic portion 4a of the paper money 4. This is because the passage region of the paper money 4 includes the specific region in which the magnetic flux density increases as a distance from the hollow magnet 1 and the magnetic detection element 3 becomes larger on the positive side in the z-direction as described above. As a result, a width of reduction from an x-direction component (a magnetization direction component of the magnetic detection element 3) of the magnetic flux density vector B1 can be shortened in the x-direction component of the magnetic flux density vector B2 as compared to the conventional case. For instance, a portion of reduction in the x-direction component due to an angular difference between the magnetic flux density vectors B1, B2 can be offset by a difference in magnitude. Therefore, if the magnetic portion 4a of the paper money 4 becomes more distant, a reduction can be suppressed in the magnetization direction component of the magnetic flux density at the magnetic sensitive point 3a of the magnetic detection element 3, and variation in output voltage of the magnetic detection element 3 can be suppressed.

Fig. 6 is a waveform diagram of output voltage of the magnetic sensor of the first embodiment when a measurement magnetic body is moved along a passage region of the paper money 4. The measurement magnetic body is a piece of paper printed with magnetic ink on the entire surface, for example. The horizontal axis of Fig. 6 indicates a center position of the measurement magnetic body in the x-direction and 0 m indicates a position immediately above the center of the N-pole side opening of the through-hole 1a of the hollow magnet 1. The magnetic sensor is designed such that the output voltage is 2.5 V when the x-component of the magnetic flux density is zero at the magnetic sensitive point 3a of the magnetic detection element 3. In Fig. 6, a waveform indicated by a dashed-dotted line is the waveform when the passage region of the measurement magnetic body is at a distance of 0.1 mm from an upper end surface of the magnetic detection element 3 on the positive side in the z-direction (when a gap is 0.1 mm), and a waveform indicated by a solid line is the waveform when the passage region of the measurement magnetic body is at a distance of 0.5 mm from the upper end surface of the magnetic detection element 3 on the positive side in the z-direction (when a gap is 0.5 mm). As depicted in Fig. 6, a difference in output voltage between the close and distant measurement magnetic bodies is generally within about 10 % in terms of a peak value (amplitude).

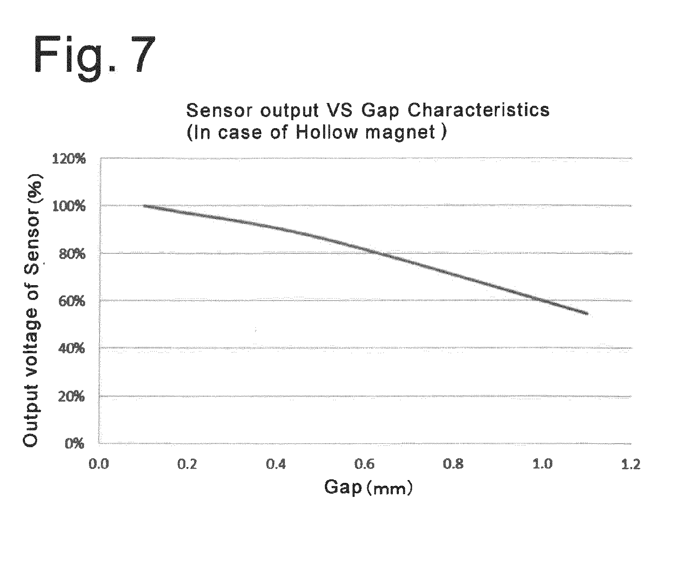

Fig. 7 is a characteristic diagram of relationship between a distance (gap) in the z-direction from the upper end surface of the magnetic detection element 3 to the passage region of the measurement magnetic body and a peak value (amplitude) of the output voltage of the magnetic sensor of the first embodiment when the measurement magnetic body is moved along the passage region of the paper money 4. The output voltage indicated by the vertical axis is indicated in percentage and is 100% when the gap is 0.1 mm. By using the hollow magnet 1 as a bias magnetic field generating means, the output voltage is gradually reduced relative to gap expansion as depicted in Fig. 7 and the reduction in the output voltage is made smaller even in a range to a gap of 0.5 mm.

Since the magnetic sensor of this embodiment is configured such that the passage region of the paper money 4 includes the specific region in which the magnetic flux density increases as a distance from the hollow magnet 1 and the magnetic detection element 3 becomes larger on the positive side in the z-direction, a reduction in sensor output voltage can be suppressed when the magnetic portion 4a of the paper money 4 moves away from the magnetic detection element 3 due to flapping of the paper money 4, and the output variation due to flapping of the paper money 4 can be suppressed.

### Second Embodiment

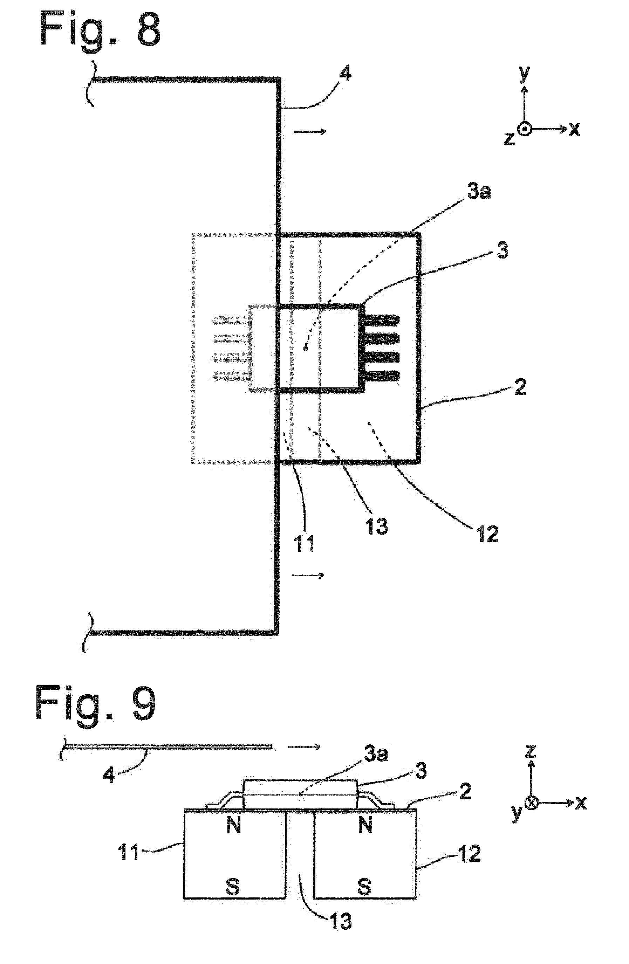

Fig. 8 is a schematic plan view of a magnetic sensor according to a second embodiment of the present invention. Fig. 9 is a schematic front view thereof. The magnetic sensor of this embodiment is identical to the magnetic sensor of the first embodiment depicted in Figs. 1 and 2 except that a bias magnetic field generating means is made up of a first magnet 11 and a second magnet 12 and that the substrate 2 is disposed (fixed) onto the N-pole side end surfaces of both the first magnet 11 and the second magnet 12. The first magnet 11 and the second magnet 12 are rectangular column magnets of the same shape, for example, and are arranged side by side across a gap 13 in the x-direction and both have the N-pole on the end surfaces on the positive side in the z-direction. The magnetic sensitive point 3a of the magnetic detection element 3 is located on a virtual straight line passing through the center of the gap 13 in parallel with the z-direction.

In this embodiment, the first magnet 11 and the second magnet 12 arranged across the gap 13 are used as the bias magnetic field generating means to form a specific region in which the magnetic flux density increases as a distance from the first magnet 11 and the second magnet 12 as well as the magnetic detection element 3 becomes larger on the positive side in the z-direction as is the case with the first embodiment. By including the specific region in the passage region of the paper money 4, a reduction in sensor output voltage can be suppressed when the magnetic portion of the paper money 4 moves away from the magnetic detection element 3 due to flapping of the paper money 4, and the output variation due to flapping of the paper money 4 can be suppressed, as is the case with the first embodiment.

### Third Embodiment

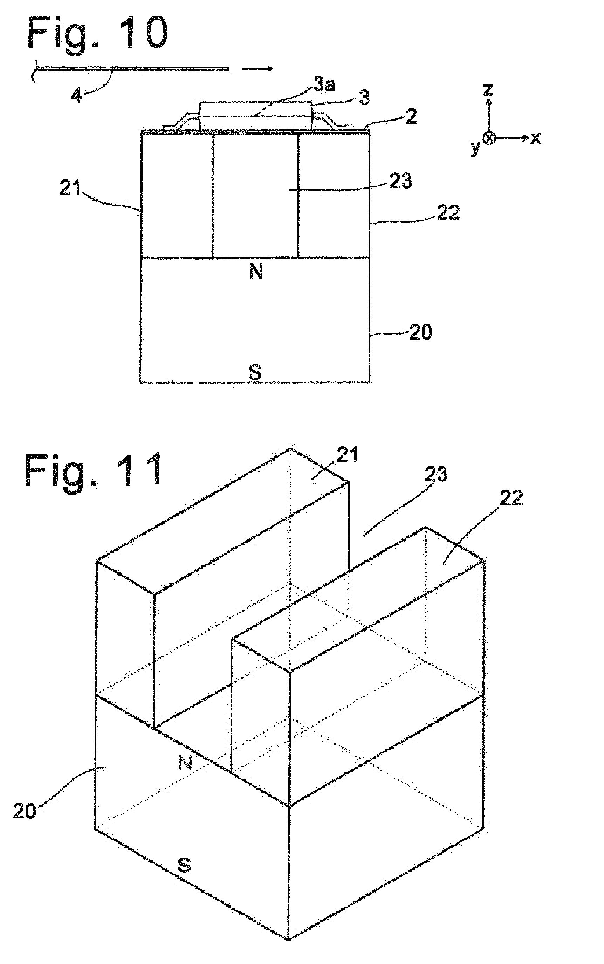

Fig. 10 is a schematic front view of a magnetic sensor according to a third embodiment of the present invention. Fig. 11 is a perspective view of a bias magnetic field generating means of the magnetic sensor of Fig. 10. The magnetic sensor of this embodiment is identical to the magnetic sensor of the first embodiment depicted in Figs. 1 and 2 except that the bias magnetic field generating means is made up of a magnet 20 as well as a first yoke 21 and a second yoke 22 and that the substrate 2 is disposed (fixed) onto the end surfaces of both the first yoke 21 and the second yoke 22 on the positive side in the z-direction. The magnet 20 is, for example, a rectangular column magnet and has the N-pole on the end surface on the positive side in the z-direction. The first yoke 21 and the second yoke 22 have the same rectangular column shape, for example, and are disposed (fixed) onto the N-pole side end surface of the magnet 20 and arranged side by side across a gap 23 in the x-direction. The magnetic sensitive point 3a of the magnetic detection element 3 is located on a virtual straight line connecting the center of the magnet 20 and the center of the gap 23.

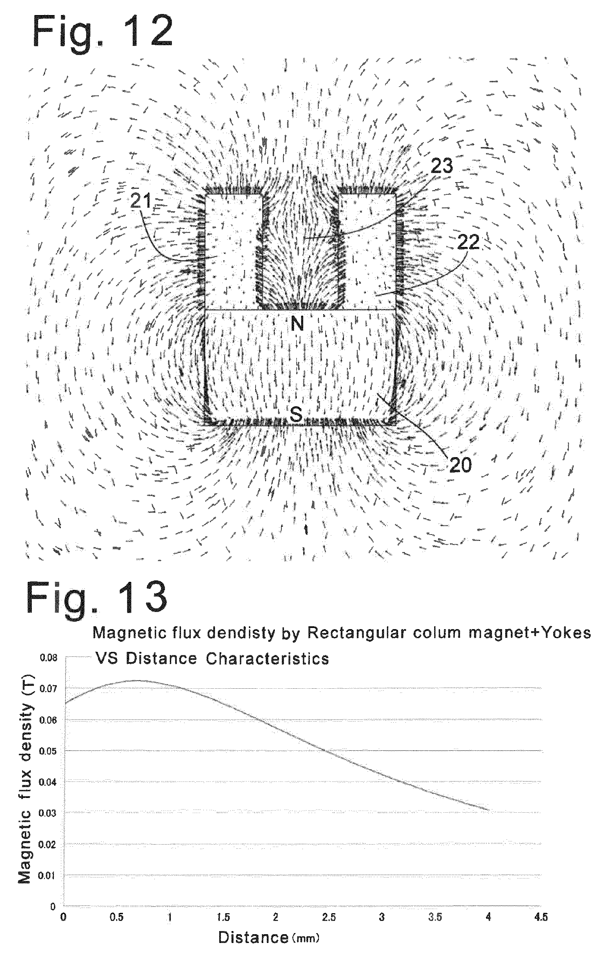

Fig. 12 is a simulated view of magnetic fluxes generated by the bias magnetic field generating means of Fig. 11 and visually illustrates magnetic fluxes on a plane including the center position of the magnetic 20 in the y-direction (depth direction) and parallel to the x-z plane. Fig. 13 is a characteristic diagram of relationship between magnetic flux density generated by the bias magnetic field generating means of Fig. 11 and distance. The result depicted in Fig. 13 is based on a size of the magnet 20 having a width of 5.0 mm, a depth of 5.0 mm, and a height of 3.0 mm and a size of the first and second yokes 21, 22 having a width of 1.5 mm, a depth of 5.0 mm, and a height of 3.0 mm. In Fig. 13, a distance indicted by the horizontal axis is a distance from an intersection between a virtual line passing through the center of the magnet 20 in parallel with the z-direction and a virtual plane including the end surfaces of the first yoke 21 and the second yoke 22 on the positive side in the z-direction to a magnetic flux density measurement point. The magnetic flux density measurement point ranges to a position at a distance of 4 mm from the intersection on the positive side in the z-direction. As depicted in Fig. 13, it is understood that the magnetic flux density increases in a range within a distance of about 0.7 mm from the intersection as the distance from the intersection becomes larger. Therefore, as is the case with the first embodiment, this embodiment forms a specific region in which the magnetic flux density increases as a distance from the magnet 20, the first yoke 21, and the second yoke 22 as well as the magnetic detection element 3 increases on the positive side in the z-direction. By including the specific region in the passage region of the paper money 4, a reduction in sensor output voltage can be suppressed when the magnetic portion of the paper money 4 moves away from the magnetic detection element 3 due to flapping of the paper money 4, and the output variation due to flapping of the paper money 4 can be suppressed, as is the case with the first embodiment.

### Comparison Example

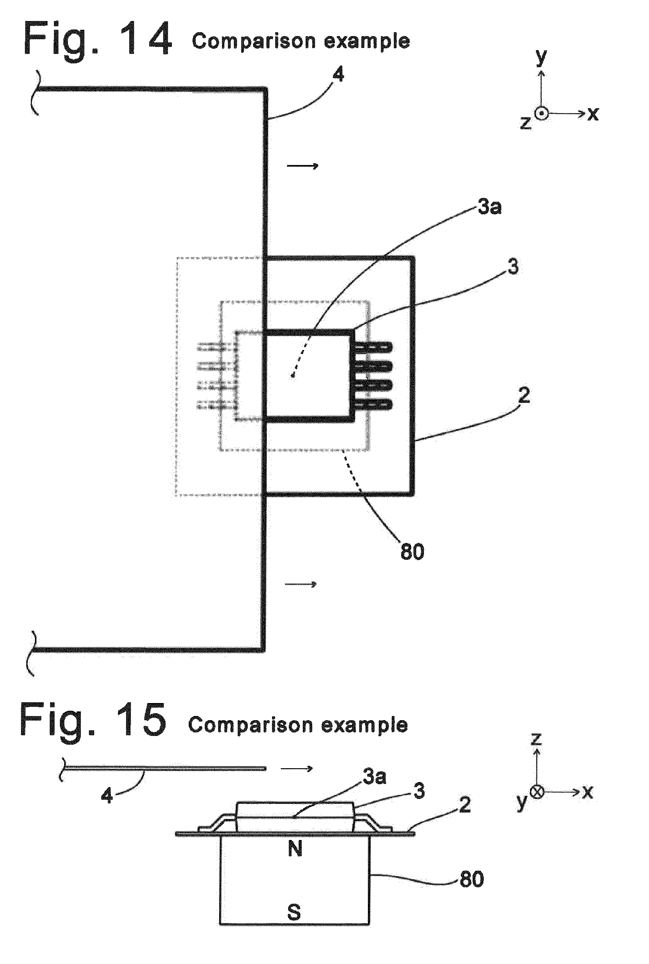

A comparison example will be described for explaining the effect of the embodiments described above. Fig. 14 is a schematic plan view of a magnetic sensor of a comparison example. Fig. 15 is a schematic front view thereof. In this comparison example, a bias magnetic field generating means is made up of one rectangular column magnet 80. The rectangular column magnet 80 has the N-pole on the entire end surface on the positive side in the z-direction and the S-pole on the entire end surface on the negative side in the z-direction. The substrate 2 is disposed (fixed) onto the N-pole side end surface of the rectangular column magnet 80. The magnetic detection element 3 is mounted on the substrate 2. The magnetic sensitive point 3a of the magnetic detection element 3 is located on a virtual line passing through the center of the rectangular column magnet 80 in parallel with the z-direction.

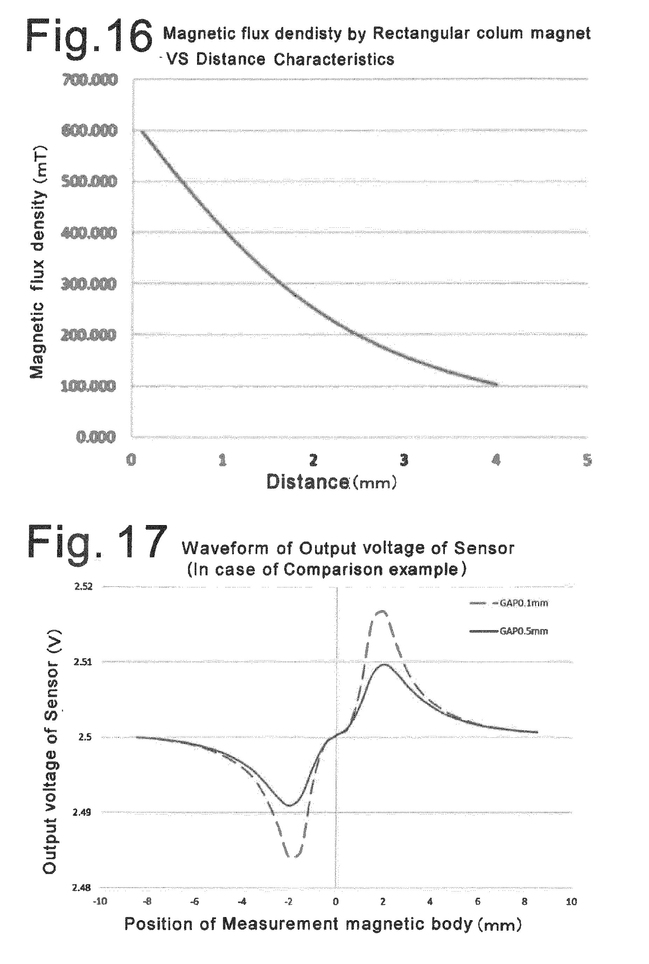

Fig. 16 is a characteristic diagram of relationship between magnetic flux density generated by the rectangular column magnet 80 and distance related to the comparison example. The result depicted in Fig. 16 is based on a size of the rectangular column magnet having a width of 5 mm, a depth of 5 mm, and a height of 9 mm. In Fig. 16, a distance indicted by the horizontal axis is a distance from the center of the N-pole side end surface of the rectangular column magnet to a magnetic flux density measurement point. The magnetic flux density measurement point ranges to a position at a distance of 4 mm from the center of the N-pole side end surface of the rectangular column magnet. As depicted in Fig. 16, in the case of the rectangular column magnet, the magnetic flux density consistently decreases as the distance from the center of the N-pole side end surface becomes larger. In other words, in the case of the rectangular column magnet, the magnetic flux density does not increase in any range as the distance from the center of the N-pole side end surface becomes larger.

Fig. 17 is a waveform diagram of output voltage of the magnetic sensor of the comparison example when the measurement magnetic body is moved along the passage region of the paper money 4. In Fig. 17, a waveform indicated by a dashed-dotted line is the waveform when the passage region of the measurement magnetic body is at a distance of 0.1 mm from the upper end surface of the magnetic detection element 3 on the positive side in the z-direction (when a gap is 0.1 mm), and a waveform indicated by a solid line is the waveform when the passage region of the measurement magnetic body is at a distance of 0.5 mm from the upper end surface of the magnetic detection element 3 on the positive side in the z-direction (when a gap is 0.5 mm). As depicted in Fig. 17, a difference in output voltage between the close and distant measurement magnetic bodies is generally made larger to about 50 % in terms of a peak value (amplitude).

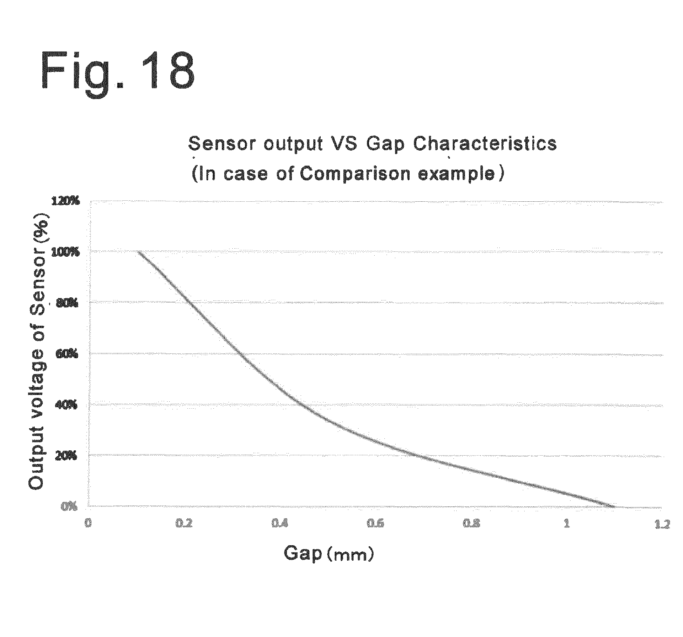

Fig. 18 is a characteristic diagram of relationship between a distance (gap) in the z-direction from the upper end surface of the magnetic detection element 3 to the passage region of the measurement magnetic body and a peak value (amplitude) of the output voltage of the magnetic sensor of the comparison example when the measurement magnetic body is moved along the passage region of the paper money 4. The output voltage indicated by the vertical axis is indicated in percentage and is 100% when the gap is 0.1 mm. If the bias magnetic field generating means is the one rectangular column magnet 80, the output voltage is sharply reduced relative to gap expansion as depicted in Fig. 18 and the output voltage is reduced to half or less when a gap is 0.5 mm.

Described above is an explanation based on the embodiment. The description of the embodiments is illustrative in nature and various variations in constituting elements and processes involved are possible. Those skilled in the art would readily appreciate that such variations are also within the scope of the present invention.

The hollow magnet 1 of the first embodiment is not limited to a circular tube shape and may be in another tube shape such as a rectangular tube shape. The first magnet 11 and the second magnet 12 of the second embodiment as well as the magnet 20, the first yoke 21, and the second yoke 22 of the third embodiment are not limited to a rectangular column shape and may be another column shape (block shape) such as a circular column shape. The magnetic sensor is usable as a multichannel product by using a plurality of the magnetic sensors of the embodiments for covering a wider area. An obj ect to be identified by the magnetic sensor may be a magnetic powder adhered medium or a magnetic film adhered medium other than paper money.

## Claims

1. A magnetic sensor comprising:
a bias magnetic field generating means; and
a magnetic detection element disposed on one side of the bias magnetic field generating means in a magnetic pole direction,
the magnetic sensor identifying a medium, that is a magnetic powder adhered medium or a magnetic film adhered medium, passing across the magnetic detection element on the side opposite to the bias magnetic field generating means,
the magnetic detection element being capable of detecting variation in a magnetic field component parallel to a movement direction of the medium to be identified,
a passage region of the medium including a specific region in which a magnetic field increases when a distance from the magnetic detection element becomes larger in the magnetic pole direction.

2. The magnetic sensor according to claim 1, wherein in at least a portion of the medium, a magnetic field at a magnetic sensitive point of the magnetic detection element increases when the medium moves away from the magnetic detection element in the magnetic pole direction.

3. The magnetic sensor according to claim 1 or 2, wherein the bias magnetic field generating means includes two magnets, and the two magnets are arranged side by side across a gap and both have the same magnetic pole as a magnetic pole closer to the magnetic detection element.

4. The magnetic sensor according to claim 1 or 2, wherein the bias magnetic field generating means includes a hollow magnet having a through-hole penetrating therethrough in the magnetic pole direction, and the hollow magnet has the same magnetic pole on an entire end surface closer to the magnetic detection element.

5. The magnetic sensor according to claim 1 or 2, wherein the bias magnetic field generating means includes a magnet and two yokes disposed on one magnetic pole face of the magnet, and the two yokes are arranged side by side across a gap.
